# FASCICULE DE BREVET EUROPEEN

(11) **EP 2 077 341 B1**
(45) Date de publication et mention de la délivrance du brevet: **06.04.2011**
(21) Numéro de dépôt: 08165847.8
(22) Date de dépôt: 03.10.2008
(51) Int. Cl.: C23C 16/12, F01D 9/02, C23C 10/06, C23C 10/04

(54) **Procédé d'aluminisation en phase vapeur d'une pièce métallique de turbomachine**
Aluminisierungsverfahren in der Dampfphase eines Metallteils eines Turbotriebwerks
Method for aluminising a metal part of a turbomachine in vapour phase

(30) Priorité: 03.10.2007 FR 0706932; 30.04.2008 FR 0852921
(43) Date de publication de la demande: 08.07.2009
(73) Titulaire: SNECMA, 75015 Paris (FR)
(72) Inventeur: LANCIAUX, Lucie, 75017, PARIS (FR); CARLIN, Maxime, 75018, PARIS (FR)
(74) Mandataire: David, Daniel

(56) Documents cités:
- EP-A- 1 361 338
- EP-A- 1 577 415
- FR-A- 2 706 171
- FR-A- 2 830 874

## Description

La présente invention concerne le dépôt d'un revêtement d'aluminium sur une pièce métallique, notamment sur une pièce métallique creuse comportant une chemise interne. Elle vise plus particulièrement l'application d'un tel revêtement sur des aubes creuses de turbomachine incorporant une chemise de distribution de fluide de refroidissement.

Un moteur à turbine à gaz, tel qu'utilisé pour la propulsion dans le domaine aéronautique comprend une entrée d'air atmosphérique qui communique avec un ou plusieurs compresseurs, dont une soufflante généralement, entraînés en rotation autour d'un même axe. Le flux primaire de cet air après avoir été comprimé alimente une chambre de combustion disposée annulairement autour de cet axe et est mélangé à un carburant pour fournir des gaz chauds en aval à une ou plusieurs turbines à travers lesquelles ceux-ci sont détendus, les rotors de turbine entraînant les rotors de compression. Les moteurs fonctionnent à une température des gaz moteurs en entrée de turbine que l'on cherche aussi élevée que possible car les performances lui sont liées. Dans ce but les matériaux sont sélectionnés pour résister à ces conditions de fonctionnement et les parois des pièces balayées par les gaz chauds, telles que les distributeurs ou les ailettes mobiles de turbine, sont pourvues de moyens de refroidissement. Par ailleurs, en raison de leur constitution métallique en superalliage à base de nickel ou de cobalt, il est nécessaire aussi de prémunir celles-ci de l'érosion et de la corrosion engendrées par les constituants des gaz moteurs à ces températures.

Un moyen connu pour assureur la protection de ces pièces est de déposer un revêtement à base d'aluminium sur les surfaces susceptibles d'agression par les gaz. L'aluminium se fixe au substrat par inter-diffusion métallique et forme une couche protectrice d'oxyde en surface. L'épaisseur du revêtement est de l'ordre de quelques dizaines de microns.

La présente invention se rapporte à la technique, en soi connue, de dépôt de l'aluminium en phase vapeur ou encore désignée aluminisation par dépôt en phase vapeur. Selon le procédé, on dispose les pièces à traiter dans une enceinte dans laquelle l'atmosphère est constituée d'un mélange d'un gaz inerte ou réducteur, par exemple argon ou hydrogène, et d'un gaz actif comprenant un halogénure d'aluminium. A la température de réaction, entre 900°C et 1150°C, l'halogénure se décompose à la surface de la pièce en halogène gazeux et en aluminium qui diffuse dans le métal.

On produit l'halogénure en disposant dans l'enceinte avec les pièces à traiter, des blocs de métal aluminium ou d'alliage d'aluminium qui forment le donneur, en présence de granules d'un composé d'halogène, chlore ou fluor, qui forment l'activateur. On fait circuler le gaz inerte sur l'activateur à une température permettant la sublimation de l'halogène qui est entraîné sur le donneur et avec lequel il réagit pour produire l'halogénure métallique qui, à cette température, est sous forme vapeur. L'halogénure se décompose ensuite au contact du substrat métallique à revêtir permettant le dépôt de l'aluminium ; l'halogène gazeux est reformé.

Lorsque les pièces statoriques aussi bien que mobiles sont pourvues de cavités internes parcourues par un fluide de refroidissement, de l'air prélevé au compresseur, on a constaté que les parois de ces cavités étaient également sujettes à corrosion. Des retours de pièces utilisées sur des moteurs travaillant dans certains environnements ont montré une attaque de ces surfaces. On a relevé, par exemple, une corrosion interne des distributeurs, des libérations de plaques de corrosion dans la cavité des distributeurs, le bouchage des trous d'évents de bord de fuite, etc. Une protection pour ces parties de pièces est donc également nécessaire.

Le mode d'aluminisation par dépôt en phase vapeur convient bien a priori pour appliquer un revêtement de protection car le gaz porteur et les composants actifs sont susceptibles de pénétrer dans les passages étroits de circulation du fluide de refroidissement dans la mesure où ces passages sont ouverts. La réalité montre que ce n'est pas le cas. L'épaisseur de la couche de protection n'est pas uniforme ; elle diminue fortement à partir des orifices d'accès des cavités. Par ailleurs des accumulations se forment au niveau des trous d'évent des cavités réduisant la section de passage et les propriétés de refroidissement de la pièce.

Dans la demande de brevet FR 2830874 au nom de la demanderesse on décrit un procédé d'aluminisation par dépôt en phase vapeur de pièces de turbomachines métalliques pourvues de trous et de cavités communiquant avec l'extérieur selon lequel un précurseur gazeux du dépôt à réaliser comprenant un composé de l'aluminium est amené avec l'aide d'un gaz porteur au contact des surfaces de la pièce disposée dans une enceinte, le gaz porteur est soi l'hélium soit l'argon et la pression dans l'enceinte est choisie de manière que le libre parcours moyen des molécules du gaz porteur est deux fois supérieur à celui des molécules d'argon sous pression atmosphérique. Le libre parcours moyen des molécules est usuellement défini comme le rapport 1/P*D² où P est la pression régnant dans l'enceinte et D le diamètre moléculaire.

Par l'allongement du libre parcours moyen des molécules du gaz porteur, la diffusion de l'halogénure dans les canaux internes est accrue et l'épaisseur du dépôt dans les zones moins accessibles par la méthode classique est augmentée ; la protection globale en est améliorée. L'augmentation du libre parcours résulte soit du choix du gaz porteur, là l'hélium, soit d'une diminution de la pression comme on peut le déduire de la formule ci-dessus.

L'invention a pour objet une variante de procédé permettant d'obtenir un revêtement des parois des cavités internes sur toute la surface avec une épaisseur suffisante.

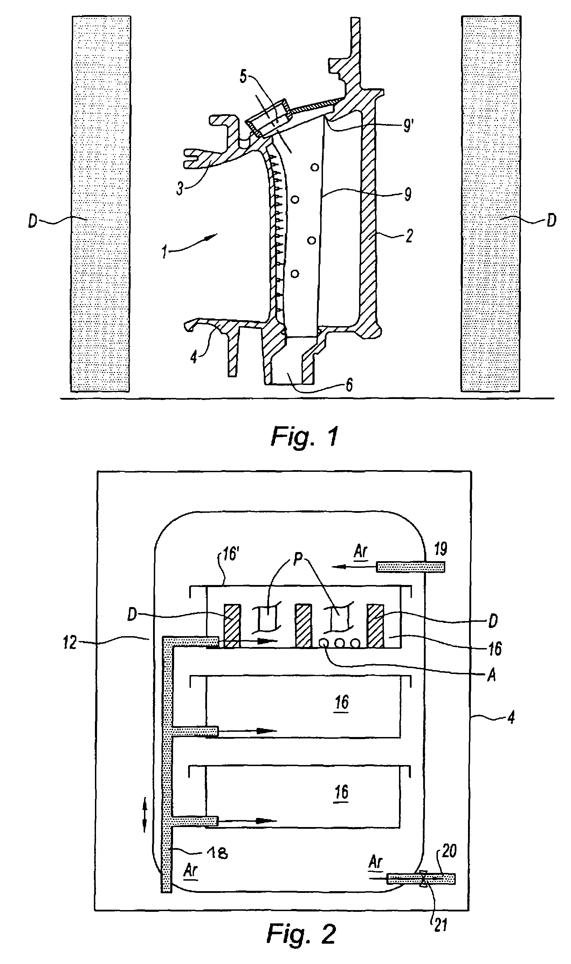

L'invention concerne les pièces creuses avec une cavité et une ouverture au moins par laquelle la cavité communique avec l'extérieur. Elle concerne de telles pièces, pourvues d'un composant telle qu'une chemise interne, à l'intérieur de la cavité, rapporté à travers l'ouverture et assemblé avec la pièce. Une telle pièce est représentée sur la figure 1. Il s'agit de la coupe d'un distributeur d'un étage à basse pression dans un moteur à turbine à gaz à double corps. L'aube 1 de distributeur comprend une partie fabriquée par coulée de métal dans un moule carapace. Cette partie, hachurée sur la figure, est formée d'une pale 2 creuse entre deux plateformes 3 et 4. La cavité de la pale 2 communique par ses deux extrémités, respectivement d'un côté avec une ouverture 5 d'alimentation en fluide de refroidissement et de l'autre côté avec une sortie de fluide 6. A l'intérieur de la cavité de la pale 2, est disposée une chemise 9 de forme sensiblement cylindrique. La chemise est soudée ou brasée du côté de l'ouverture 5 d'alimentation en air de refroidissement par une brasure/soudure périphérique le long du bord de l'ouverture de la cavité. L'autre extrémité de la chemise est engagée dans un logement cylindrique communiquant avec la sortie 6, sans y être soudée pour permettre la dilation relative de la chemise par rapport à la pale pendant les étapes de fonctionnement transitoires. La chemise est perforée sur sa longueur et ménage un espace avec la paroi de la pale de telle façon que l'air de refroidissement provenant de l'ouverture 5 d'alimentation en air passe pour partie à travers les perforations de la chemise et forme une pluralité de jets d'air refroidissant la paroi de la pale par impact et convection. Cet air est ensuite évacué par des évents ménagés à proximité du bord de fuite de la pale. L'air qui n'a pas traversé la paroi de la chemise est guidé vers l'ouverture 6 pour être conduit vers d'autres parties de la machine.

En fabrication, la chemise 9, réalisée séparément de la pale, est rapportée dans la pale en étant glissée à travers l'orifice 5 puis brasée à proximité de l'embouchure comme mentionné plus haut. La partie inférieure, sur la figure, reste libre de se dilater et de coulisser dans le logement formé par l'ouverture 6.

Conventionnellement, le traitement d'aluminisation d'une pièce comme celle-ci est effectué après qu'elle a été assemblée.

Conformément à l'invention, on améliore sensiblement le dépôt d'aluminure à l'intérieur de la cavité avec le procédé suivant, applicable à toute pièce comprenant un composant pouvant être glissé par une ouverture et assemblé à l'intérieur de la pièce :
Le procédé d'aluminisation par dépôt en phase vapeur pour la protection contre l'oxydation à haute température d'une pièce métallique creuse de turbomachine,
   Ladite pièce comportant une cavité dans laquelle est rapporté et assemblé un composant métallique depuis une ouverture dans ladite pièce,
   Procédé selon lequel un halogénure est formé par réaction entre un halogène et un donneur métallique contenant de l'aluminium, puis l'halogénure est transporté par un gaz porteur pour venir au contact de ladite pièce métallique,
   Est caractérisé par le fait que le composant a été au préalable, avant la mise en oeuvre du procédé, enrichi en surface en aluminium de façon à servir de donneur d'aluminium.

En apportant un donneur, à l'intérieur de la cavité, constitué par le composant enrichi en surface, on permet un dépôt efficace. On résout notamment le problème d'accessibilité depuis l'extérieur de la pièce tout en maîtrisant la quantité de donneur interne.

En effet le composant est revêtu de préférence d'une couche réalisée par dépôt de métal. Ce dépôt peut avoir été réalisé par toute méthode à la portée de l'homme du métier : aluminisation par dépôt en phase vapeur (APVS ou CVD, aluminisation par cémentation en pack), dépôt sous vide (PVD), projection thermique, électrodéposition, par immersion dans un bain (dip coating), etc.

On maîtrise notamment la quantité de donneur par l'épaisseur de la couche ; elle est par exemple comprise entre 10µm et 150µm, de préférence comprise entre 20 et 90µm.

La couche contient au moins 15% massique d'aluminium mais peut comprendre également au moins un élément connu pour ces propriétés d'amélioration de la tenue à l'oxydation et compris dans l'ensemble (Cr, Hf, Y, Zr, Si, Ti, Ta, Pt, Pd, Ir), en particulier l'élément Cr.

Comme cela l'a été précisé ci-dessus, le procédé convient avantageusement au traitement d'aluminisation d'une aube creuse de turbomachine. Ledit composant est alors constitué de la chemise perforée de distribution de fluide de refroidissement à l'intérieur de la cavité.

L'aube est une aube de distributeur avec une pale pourvue d'une cavité et d'une chemise dans la cavité. La chemise est introduite, après avoir été enrichie en métal donneur, par une ouverture ménagée à une extrémité de la pale. Ensuite la chemise est soudée par une extrémité à la paroi de la pale du côté de l'ouverture d'introduction de la chemise dans la cavité.

On décrit maintenant un mode de réalisation, non limitatif, de l'invention en référence aux dessins sur lesquels :
La figure 1 représente une aube de distributeur avec cavité interne et chemise de distribution d'air de refroidissement rapportée dans cette cavité.
La figure 2 montre une installation d'aluminisation convenant pour la mise en oeuvre du procédé de l'invention.
La figure 3 montre l'épaisseur de revêtement obtenu en interne à la fois par la technique de l'art antérieur et la technique selon l'invention.

La figure 2 montre très schématiquement une installation conventionnelle d'aluminisation par dépôt en phase vapeur dans laquelle on met en oeuvre le procédé de l'invention.

Une enceinte 12 est montée à l'intérieur d'un four 4 capable de chauffer les pièces à une température de 1200°C. Dans cette enceinte sont disposés des boîtes 16, ici trois superposées, avec un couvercle 16'. Ces boîtes contiennent les pièces à traiter P, par exemple des distributeurs de turbine, avec le donneur D métallique sous forme de poudre ou de blocs et l'activateur A. L'enceinte 12 comprend une alimentation 18 en gaz porteur de purge, une alimentation 19 en gaz porteur de balayage et une évacuation 20 commandée par une vanne 21.

Après avoir disposé les pièces, le donneur et l'activateur dans les boîtes 16, on commence par purger l'enceinte 12 en introduisant le gaz porteur, argon par exemple par la conduite 18. On interrompt l'alimentation quand l'air de l'enceinte a été replacé par l'argon. On actionne ensuite le chauffage du four tout en alimentant l'enceinte en argon par la conduite 19. L'excès de gaz est évacué par le conduit 20. À la température d'activation de l'activateur A, l'halogène, chlore ou fluor, est libéré. En venant au contact du donneur l'halogène réagit avec le métal et forme un halogénure. La vapeur d'halogénure ainsi formée circule à l'intérieur des boîtes 16 et vient au contact des pièces métalliques P. A ce moment l'halogénure se décompose et libère le métal qui se dépose sur la pièce.

L'argon est introduit en permanence, en balayage léger, par la conduite 19 dans l'enceinte 12 et est évacué par le conduit 20. La durée du traitement est comprise entre 2 et 6 heures.

Conformément à l'invention, on rapproche le donneur de la cavité en se servant de la chemise comme donneur.

En préalable au traitement d'aluminisation, on prépare la pièce en assemblant une chemise enrichie en aluminium et la pièce venue de coulée. On introduit la chemise à travers le passage 5 d'alimentation en air de refroidissement de la pale. On brase ensuite le bord supérieur 9' de la chemise 9 à la paroi de l'ouverture dans la pale.

La chemise a été enrichie en aluminium par tout moyen à la portée de l'homme du métier.

La chemise peut ainsi avoir elle-même été traitée par aluminisation en phase vapeur avec pour objectif de réaliser une couche sur toute la surface. L'épaisseur de la couche est déterminée de manière à disposer d'une quantité d'aluminium suffisante pour réagir avec l'halogène et former un halogénure en phase vapeur pendant l'opération d'aluminisation de la pièce. Comme le donneur est proche des surfaces à traiter, le dépôt obtenu est supérieur à celui qui pourrait être obtenu par la méthode conventionnelle.

L'avantage de cette solution par rapport à une autre solution qui consisterait à disposer un panier donneur à l'intérieur de la cavité, est de permettre le traitement de la pièce déjà assemblée. L'emploi d'un panier dans une étape intermédiaire obligerait à traiter la pièce sans la chemise puis à monter la chemise sur la pièce dont les parois sont revêtues d'une couche d'aluminium ce qui nécessite une adaptation particulière des moyens de brasage.

Par ailleurs il n'est pas nécessaire de développer une technique spécifique de nettoyage de l'intérieur de la cavité de résidus de donneur.

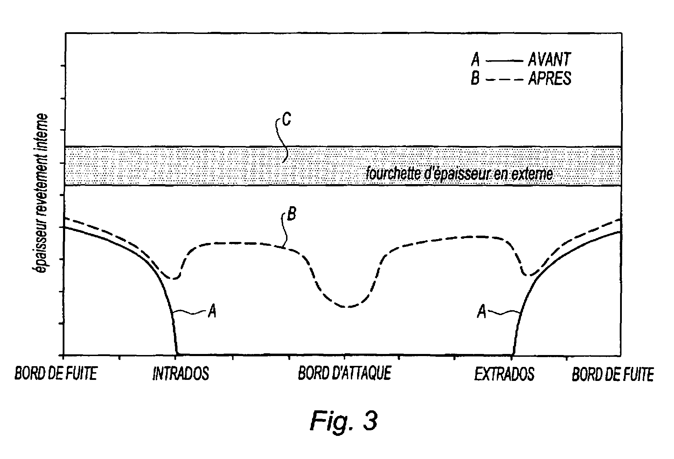

Sur la figure 3, on a représenté la répartition, en ordonnée, de l'épaisseur de revêtement obtenu sur les parois de la cavité. La courbe A correspondant à l'art antérieur montre que le revêtement est très mal réparti entre le bord d'attaque et le bord de fuite à la fois le long de l'intrados et de l'extrados. La courbe B représente l'épaisseur du revêtement obtenu avec la chemise donneuse. Il est plus homogène et non nul. La zone C montre l'épaisseur en externe.

## Revendications

1. Procédé d'aluminisation par dépôt en phase vapeur pour la protection contre l'oxydation à haute température d'une pièce métallique de turbomachine,
Ladite pièce (1) comportant une cavité dans laquelle est rapporté et assemblé un composant métallique (9) depuis une ouverture (5) dans ladite pièce,
Procédé selon lequel un halogénure est formé par réaction entre un halogène et un donneur métallique contenant de l'aluminium, puis l'halogénure est transporté par un gaz porteur pour venir au contact de ladite pièce métallique,
**Caractérisé par le fait que** le composant métallique (9) a été au préalable, avant la mise en oeuvre du procédé, enrichi en surface en aluminium de façon à servir de donneur d'aluminium.

2. Procédé selon la revendication précédente dont le composant (9) est revêtu d'une couche réalisée par dépôt de métal.

3. Procédé selon la revendication précédente dont le dépôt de métal sur le composant a été effectué par l'une des méthodes suivantes : APVS, CVD, PVD, aluminisation par cémentation en pack, projection thermique, électrodéposition, immersion dans un bain.

4. Procédé selon la revendication 2 ou 3 dont la couche a une épaisseur comprise entre 10µm et 150µm.

5. Procédé selon la revendication précédente dont la couche a une épaisseur comprise entre 20 et 90µm.

6. Procédé selon l'une des revendications précédentes dont la couche contient au moins 15% massique d'aluminium.

7. Procédé selon la revendication précédente dont la couche comprend également au moins un élément d'amélioration de la tenue à l'oxydation compris dans l'ensemble (Cr, Hf, Y, Zr, Si, Ti, Ta, Pt, Pd, Ir)

8. Procédé selon l'une des revendications précédentes pour le traitement d'aluminisation d'une aube (1) creuse de turbomachine, ledit composant (9) étant constitué d'une chemise perforée de distribution de fluide de refroidissement à l'intérieur de la cavité.

9. Procédé selon la revendication précédente dont l'aube est une aube de distributeur avec une pale (2) pourvue d'une cavité et de ladite chemise (9) dans la cavité.

10. Procédé selon la revendication précédente dont la chemise (9) est introduite dans la cavité, après avoir été enrichie en métal, par une ouverture (5) ménagée à une extrémité de la pale.

11. Procédé selon la revendication précédente dont la chemise est soudée ou brasée par une extrémité à la paroi de la pale du côté de l'ouverture d'introduction de la chemise dans la cavité.

## Claims

1. An aluminization process by vapor phase deposition for high-temperature oxidation protection of a metal turbomachine part;
said part (1) comprising a cavity into which a metal component (9) is introduced and assembled from an opening (5) in said part;
according to which process a halide is formed by reaction between a halogen and a metal donor containing aluminum, then the halide is transported by a carrier gas in order to come into contact with said metal part,
wherein the metal component (9) has first, before the implementation of the process, been surface-enriched with aluminum in order to serve as an aluminum donor.

2. The process as claimed in the preceding claim, wherein the component (9) is coated with a layer formed by metal deposition.

3. The process as claimed in the preceding claim, wherein the metal deposition onto the component has been carried out by one of the following methods: SVPA, CVD, PVD, aluminization by pack cementation, thermal spraying, electrodeposition or immersion in a bath.

4. The process as claimed in claim 2 or 3, wherein the layer has a thickness between 10 µm and 150 µm.

5. The process as claimed in the preceding claim, wherein the layer has a thickness between 20 and 90 µm.

6. The process as claimed in one of the preceding claims, wherein the layer contains at least 15 wt% of aluminum.

7. The process as claimed in the preceding claim, wherein the layer also comprises at least one element for improving the oxidation resistance from among the set (Cr, Hf, Y, Zr, Si, Ti, Ta, Pt, Pd, Ir).

8. The process as claimed in one of the preceding claims, for the aluminization treatment of a hollow turbomachine vane (1), said component (9) being made up of a perforated liner for distributing coolant inside the cavity.

9. The process as claimed in the preceding claim, wherein the vane is a nozzle guide vane with a blade (2) provided with a cavity and with said liner (9) in the cavity.

10. The process as claimed in the preceding claim, wherein the liner (9) is introduced into the cavity, after having been enriched with metal, via an opening (5) made in one end of the blade.

11. The process as claimed in the preceding claim, wherein the liner is welded or brazed via one end to the wall of the blade on the side of the opening for introducing the liner into the cavity.

## Patentansprüche

1. Verfahren zur Aluminisierung durch Ablage in der Dampfphase zum Schutz gegen die Oxidierung bei hoher Temperatur eines Metallstücks eines Turbotriebwerks,
wobei das Stück (1) einen Hohlraum umfasst, in dem eine Metallkomponente (9) von einer Öffnung (5) in dem Stück aufmontiert und zusammengebaut wird,
Verfahren, nach dem ein Halogenid durch Reaktion zwischen einem Halogen und einem Metalldonor, umfassend Aluminium, gebildet wird, dann das Halogenid durch ein Trägergas transportiert wird, um mit dem metallischen Stück in Kontakt zu kommen,
**dadurch gekennzeichnet, dass** die Metallkomponente (9) im Voraus, vor der Durchführung des Verfahrens, auf der Oberfläche mit Aluminium angereichert wurde, um als Aluminiumdonor zu dienen.

2. Verfahren nach dem vorhergehenden Anspruch, wobei die Komponente (9) mit einer Lage beschichtet ist, die durch Metallablage durchgeführt wird.

3. Verfahren nach dem vorhergehenden Anspruch, wobei die Metallablage auf der Komponente durch eines der folgenden Verfahren durchgeführt wurde: APVS, CVD, PVD, Aluminisierung durch Packzementation, thermische Projektion, elektrolytisches Abscheiden Eintauchen in ein Bad.

4. Verfahren nach Anspruch 2 oder 3, wobei die Lage eine Dicke zwischen 10 µm und 150 µm aufweist.

5. Verfahren nach dem vorhergehenden Anspruch, wobei die Lage eine Dicke zwischen 20 und 90 µm aufweist.

6. Verfahren nach einem der vorhergehenden Ansprüche, wobei die Lage mindestens 15 Massen-% Aluminium enthält.

7. Verfahren nach einem der vorhergehenden Ansprüche, wobei die Lage auch mindestens ein Element zur Verbesserung der Oxidationsbeständigkeit umfasst, enthalten in der Gruppe (Cr, Hf, Y, Zr, Si, Ti, Ta, Pt, Pd, Ir).

8. Verfahren nach einem der vorhergehenden Ansprüche für die Aluminisierungsbehandlung einer hohlen Laufradschaufel (1) eines Turbotriebwerks, wobei die Komponente (9) aus einer perforierten Hülle zur Verteilung von Kühlfluid im Inneren des Hohlraums gebildet ist.

9. Verfahren nach dem vorhergehenden Anspruch, wobei die Laufradschaufel eine Leitlaufradschaufel mit einem Blatt (2) ist, versehen mit einem Hohlraum und der Hülle (9) in dem Hohlraum.

10. Verfahren nach dem vorhergehenden Anspruch, wobei die Hülle (9), nachdem sie mit Metall angereichert wurde, durch eine Öffnung (5), angebracht an einem Ende des Blattes, in den Hohlraum eingeführt wird.

11. Verfahren nach dem vorhergehenden Anspruch, wobei die Hülle an einem Ende an die Wand des Blatts an der Seite der Einführungsöffnung der Hülle in den Hohlraum geschweißt oder gelötet ist.
